# FASCICULE DE BREVET EUROPEEN

(11) **EP 0 867 950 B1**
(45) Date de publication et mention de la délivrance du brevet: **18.08.2004**
(21) Numéro de dépôt: 98400669.2
(22) Date de dépôt: 23.03.1998
(51) Int. Cl.: H01L 39/14

(54) **Procédé de découplage d'un brin multifilamentaire supraconducteur Htc à matrice à base d'argent, et brin multifilamentaire ainsi réalisé**
Verfahren zur Entkopplung eines HTc multifilamentären Draht mit silberner Matrix und so hergestellter multifilamentärer Draht
Method of decoupling a HTc multifilamentary wire with silver matrix and so produced multifilamentary wire

(30) Priorité: 27.03.1997 FR 9703752
(43) Date de publication de la demande: 30.09.1998
(73) Titulaire: Nexans, 75008 Paris (FR)
(72) Inventeur: Duperray, Gérard, 91290 La Norville (FR); Grivon, Fernand, 91240 Saint-Michel-Sur-Orge (FR); Herrmann, Peter Friedrich, 91410 Corbeuse (FR)
(74) Mandataire: Feray, Valérie

(56) Documents cités:
- EP-A- 0 966 767
- WO-A-96/28853
- Huang Y.B. ET AL, Article presented to the SPA 97 Conference, Xu'An, China, 6-8.03.1997.

## Description

L'invention concerne un brin supraconducteur multifilamentaire à Haute Température critique (HTc) et un procédé de fabrication d'un tel brin. Plus particulièrement l'invention concerne un brin supraconducteur HTc multifilamentaire à gainage d'argent utilisé en courant alternatif, et un procédé de fabrication d'un tel brin.

L'utilisation en courant alternatif des brins supraconducteurs multifilamentaires HTc provoque des pertes par courants induits. Il est connu de réduire ces pertes en torsadant le conducteur avec un pas très petit et en diminuant le diamètre des filaments. Ce moyen n'est cependant efficace que si les filaments sont électriquement découplés les uns des autres par une barrière résistive.

Il est connu de réaliser des brins multifilamentaires HTc par la technologie "Poudre En Tube" (Powder In Tube). Cela consiste à remplir une billette de réactifs poudreux susceptibles, après traitement thermique, de se transformer en matériau supraconducteur notamment du type céramique HTc.

Cette billette est ensuite fermée sous vide et étirée, mise en faisceau dans une nouvelle billette elle-même fermée sous vide et étirée à son tour. Le brin multifilamentaire résultant peut subir les mêmes étapes, et ainsi de suite jusqu'au nombre de filaments par unité de surface voulu.

Le brin ainsi réalisé est alors mis en forme définitive par exemple par laminage et/ou torsadage, puis traité thermiquement pour la transformation des réactifs poudreux.

On sait que le matériau constitutif des billettes doit être suffisamment ductile pour pouvoir subir les différentes phases d'étirages et de laminage, et avoir une composition inerte ou du moins sans conséquences pour le traitement thermique de transformation des réactifs poudreux en phase supraconductrice. Il est connu d'utiliser l'argent comme matériau constitutif des billettes.

Cependant, l'argent est un matériau très conducteur aux températures de fonctionnement des supraconducteurs HTc. De ce fait le découplage électrique entre filaments est quasiment inexistant.

Il est connu de doper l'Ag avec des impuretés du type Pd ou Au à 1 ou 2 %. Cette technique permet de gagner 2 décades de résistivité à 20 K.

Cependant l'alliage Ag/Pd est coûteux ce qui le rend économiquement rédhibitoire dans des applications de grande série.

Il est aussi connu de réaliser au moins une billette composite multicouche comprenant au moins une épaisseur extérieure d'alliage métallique dont un au moins des composants est oxydable et une épaisseur intérieure d'argent.

On effectue alors un traitement thermique de sorte que les composants oxydables de l'alliage métallique diffusent à l'interface alliage métallique/argent et, en présence d'oxygène ou de composés oxygénés, s'oxydent en formant un oxyde isolant à ladite interface.

Le découplage des filaments est ainsi sensiblement amélioré cependant, la réalisation de cette barrière d'oxyde est consommatrice d'oxygène ce qui empêche les précurseurs d'être convenablement synthétisés en phase supraconductrice.

Pour pallier ce problème il a été proposé (Y.B. HUANG, R. FLUKIGER Article présenté à SPA'97, 6-8 Mars 1997, XU'AN, Chine) d'utiliser comme barrière isolante, un composé ayant le même comportement que les précurseurs, c'est à dire perméable à l'oxygène, tout en étant un mauvais supraconducteur aux températures de fonctionnement des brins multifilamentaires HTc. On connaît de tel composé, par exemple du Bi2202 qui n'est pas un bon supraconducteur ou du Bi2212 dégénéré par une pollution de Al, de Mg, ou de TI. Dans le cas du Bi2212 il y a, par exemple, création de SrAl₂O₄ ou de CaAl₂O₄ ce qui brise la stoechiométrie nécessaire pour avoir une phase supraconductrice Bi2212.

WO-96 28853-A décrit un brin multifilamentaire supraconducteur comprenant une pluralité de filaments supraconducteurs, chaque filament supraconducteur comprenant un coeur en céramique supraconductrice, ledit coeur en céramique supraconductrice étant entouré par une première gaine en alliage à base d'Ag, elle même entourée par une couche de grande résistivité d'oxyde de métalperméable à l'oxygène, par exemple en forme de une matrice métallique dans laquelle on disperse des particules d'oxyde de métal, par exemple de l'Al₂O_{3'} elle même entourée d'une seconde gaine en alliage à base d'Ag. La section des billettes mono et multifilamentaires a une forme carrée ou rectangulaire, ronde ou hexagonale. Les brins sont contenus dans une gaine d'alliage résistif.

EP-0966767+, publiée le 2.7.1998 et avec une date de priorité du 20.12.1996, propose un brin multifilamentaire supraconducteur, chaque filament supraconducteur comprenant un coeur en céramique supraconductrice et entourée par une première gaine en alliage à base d'Ag, elle même entourée par une couche de grande résistivité de Bi(2212) pollué par Fe, Ni ou Co.

L'un des buts de la présente invention est de proposer un procédé de fabrication utilisant la dernière approche proposée permettant d'avoir un brin multifilamentaire de grande longueur dont le découplage des filaments est sensiblement amélioré, tout en maintenant une bonne perméabilité de la couche non-conductrice à l'oxygène en vu de la synthèse des précurseurs vers la phase supraconductrice.

A cet effet l'invention concerne un procédé de fabrication du type poudre en tube d'un brin multifilamentaire supraconducteur HTc à matrice à base d'argent, dans lequel :
dans une étape monofilamentaire, on remplit une première enveloppe à base d'argent, de réactifs poudreux susceptibles après traitement thermique de se transformer en matériau supraconducteur HTc;
on étire la billette résultante en un brin monofilamentaire;
dans une première étape multifilamentaire, on tronçonne ledit brin monofilamentaire et on remplit une enveloppe secondaire à base d'argent avec les tronçons résultants, réalisant ainsi une billette multifilamentaire, la billette multifilamentaire étant étirée à son tour en un brin multifilamentaire;
dans une étape multifilamentaire secondaire, réalisées au moins une fois,
on tronçonne ledit brin multifilamentaire et on remplit une nouvelle enveloppe à base d'argent avec les tronçons résultants, réalisant ainsi une nouvelle billette multifilamentaire, la nouvelle billette multifilamentaire étant étirée à son tour en un nouveau brin multifilamentaire;
on réalise une mise en forme du nouveau brin multifilamentaire;
on effectue un traitement thermiquement du brin mis en forme;
selon l'invention, lors d'une étape préalable à l'étape monofilamentaire :
on prépare selon un procédé dérivé de celui décrit dans le brevet européen EP 0 531 188 du 11 Décembre 1996 un matériau multicouche composite comprenant au moins une feuille à base d'argent et au moins une couche de matériau céramique non supraconductrice, perméable à l'oxygène à base de Bi2212 pollué par exemple par de l'Al, ou du Mg, ou du Ti ou à base de Bi2201, et
durant l'étape monofilamentaire on intercale une épaisseur de matériau multicouche composite entre une première et une deuxième épaisseur de matériau à base d'argent, formant ainsi ladite une première enveloppe à base d'argent.

Afin d'améliorer encore les performances du brin multifilamentaire, les coupes transversales de la première enveloppe à base d'argent, du brin monofilamentaire, de l'enveloppe secondaire à base d'argent, du brin multifilamentaire, de la nouvelle enveloppe à base d'argent, du nouveau brin multifilamentaire, ont une forme générale de préférence carrée ou rectangulaire bien que toute autre forme, par exemple ronde ou hexagonale soit également acceptable.

Dans un mode de réalisation, pour préparer le matériau multicouche composite :
on mélange un polymère avec une poudre susceptible après traitement thermique de se transformer en matériau céramique non supraconducteur perméable à l'oxygène, à une température de l'ordre de la température de fusion du polymère utilisé, pour obtenir un mélange homogène polymère/poudre
on compresse à chaud, au moins une feuille d'argent avec le mélange homogène polymère/poudre à une température de l'ordre de la température de fusion du polymère utilisé, pour obtenir un matériau intermédiaire multicouches composite alliage d'argent et mélange homogène polymère/poudre,
on cuit le matériau multicouche composite alliage d'argent/mélange homogène polymère/poudre à une température de l'ordre de la température de fusion de la poudre pour éliminer le polymère, assurer la synthèse de la poudre en céramique non supraconductrice perméable à l'oxygène et assurer l'adhérence de la céramique non supraconducteur perméable à l'oxygène à la feuille d'argent, réalisant ainsi le matériau multicouche composite.

Il peut être prévu de compresser à chaud le mélange homogène polymère/poudre entre deux feuilles à base d'argent.

On choisit l'épaisseur de la couche de mélange homogène polymère/poudre en fonction de l'épaisseur de céramique non supraconducteur perméable à l'oxygène, voulue autour des monofilaments du nouveau brin multifilamentaire mis en forme.

L'invention concerne aussi un brin multifilamentaire supraconducteur HTc selon la revendication 1.

Un premier avantage de la présente invention résulte de la similitude des compositions entre les précurseurs et la céramique non supraconductrice. Cela pallie tout problème de compatibilité chimique.

Un autre avantage de la présente invention résulte du fait que les étapes de traitement mécaniques et/ thermique du procédé selon l'invention ne sont pas modifiées par rapport aux étapes classiques. Cela permet donc d'utiliser des installations existantes sans adaptation.

Les gains en résistivité de la barrière céramique sont de l'ordre de 10³ à 300K et de 10⁵ à 20K par rapport à l'argent.

D'autres avantages et caractéristiques de la présente invention résulteront de la description qui va suivre en référence aux dessins annexés dans lesquels :

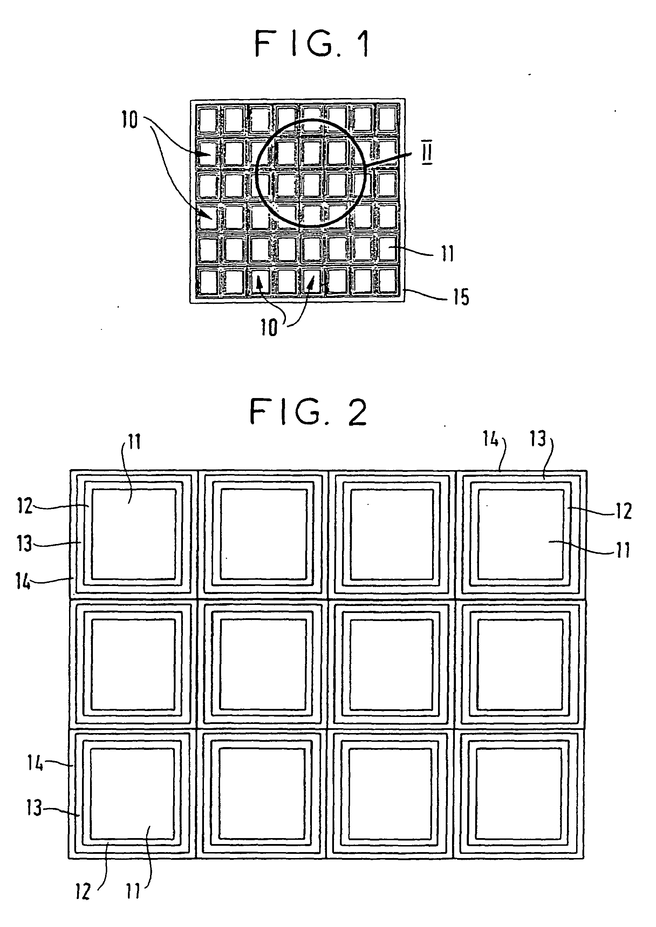

la figure 1 montre un brin multifilamentaire selon l'invention en coupe transversale dans la version carrée.
La figure 2 montre un détail du brin multifilamentaire selon l'invention représenté en figure 1 dans la version carré.
Les figures 3A, 3B, 3C, sont des représentations schématiques de variante de réalisation du matériau multicouche composite selon l'invention.

Dans la description qui va suivre on entend par non-supraconducteur un matériau qui n'a pas de propriété supraconductrice, c'est à dire que pour la température de fonctionnement des supraconducteurs HTc sa résistivité n'est pas nulle (environ 2mΩ/cm).

En outre on entend par perméable à l'oxygène le fait que le matériau est en équilibre réversible avec l'oxygène. Cela veut dire que l'oxygène capté forme avec les composants du matériau des oxydes réversibles (comme avec l'Ag). De ce fait, si il y a une demande d'oxygène pour les précurseurs, les oxydes libèrent l'oxygène vers les précurseurs.

L'invention concerne un procédé de fabrication du type poudre en tube d'un brin multifilamentaire supraconducteur HTc à matrice à base d'argent.

Les procédés poudre en tube comprennent les étapes suivantes :
une étape monofilamentaire dans laquelle
   on remplit une première enveloppe à base d'argent, de réactifs poudreux susceptibles après traitement thermique de se transformer en matériau supraconducteur HTc, et
   on étire la billette résultante en un brin monofilamentaire;
une première étape multifilamentaire dans laquelle :
   on tronçonne ledit brin monofilamentaire et on remplit une enveloppe secondaire à base d'argent avec les tronçons résultants, réalisant ainsi une billette multifilamentaire,
   la billette multifilamentaire est étirée à son tour en un brin multifilamentaire;
une étape multifilamentaire secondaire, réalisée au moins une fois, dans laquelle :
   on tronçonne ledit brin multifilamentaire et on remplit une nouvelle enveloppe à base d'argent avec les tronçons résultants, réalisant ainsi une nouvelle billette multifilamentaire, la nouvelle billette multifilamentaire étant étirée à son tour en un nouveau brin multifilamentaire;
des étapes de mise en forme et de traitement thermique dans lesquels respectivement
   on réalise une mise en forme du nouveau brin multifilamentaire; et
   on effectue un traitement thermique du brin mis en forme.

Afin d'améliorer sensiblement le découplage des filaments du brin multifilamentaire tout en maintenant une perméabilité à l'oxygène, le procédé comprend les étapes complémentaires suivantes:
préalablement à l'étape monofilamentaire :
   on prépare un matériau multicouche composite comprenant au moins une feuille à base d'argent et au moins une couche de matériau céramique non supraconductrice, perméable à l'oxygène à base de Bi2212 pollué par exemple par de l'Al, ou du Mg, ou du Ti ou à base de Bi2201, et
durant l'étape monofilamentaire :
   on intercale le matériau multicouche composite entre une première et une deuxième épaisseur de matériau à base d'argent, formant ainsi ladite une première enveloppe à base d'argent.

La couche de matériau céramique non supraconductrice, perméable à l'oxygène, constitue, du fait de sa non-supraconductivité, une couche peu conductrice découplant efficacement les filaments les uns des autres, et la forme céramique perméable à l'oxygène permet l'acheminement de l'oxygène nécessaire vers les précurseurs à travers la couche peu conductrice, pour obtenir une synthèse complète des précurseurs en phase supraconductrice lors du traitement thermique de synthèse.

Avantageusement et comme représenté sur les figures, les coupes transversales, de la première enveloppe à base d'argent, du brin monofilamentaire, de l'enveloppe secondaire à base d'argent, du brin multifilamentaire, de la nouvelle enveloppe à base d'argent, du nouveau brin multifilamentaire, ont une forme générale de préférence carrée ou rectangulaire bien que toute autre forme, par exemple ronde ou hexagonale soit également acceptable.

Pour préparer le matériau multicouche composite,
on mélange un polymère avec une poudre susceptible après traitement thermique de se transformer en matériau céramique non supraconducteur perméable à l'oxygène. Le mélange se fait à une température de l'ordre de la température de fusion du polymère utilisé, pour obtenir un mélange homogène polymère/poudre.

On compresse à chaud, au moins une feuille d'argent avec le mélange homogène polymère/poudre. Là aussi, la température est de l'ordre de la température de fusion du polymère utilisé. On obtient ainsi un matériau intermédiaire multicouche composite alliage d'argent et mélange homogène polymère/poudre.

On cuit le matériau multicouche composite alliage d'argent/mélange homogène polymère/poudre à une température de l'ordre de la température de fusion de la poudre pour :
éliminer le polymère,
assurer la synthèse de la poudre en céramique non supraconductrice perméable à l'oxygène, et
assurer l'adhérence de la céramique non supraconductrice perméable à l'oxygène à la feuille d'argent.

On obtient ainsi le matériau multicouche composite.

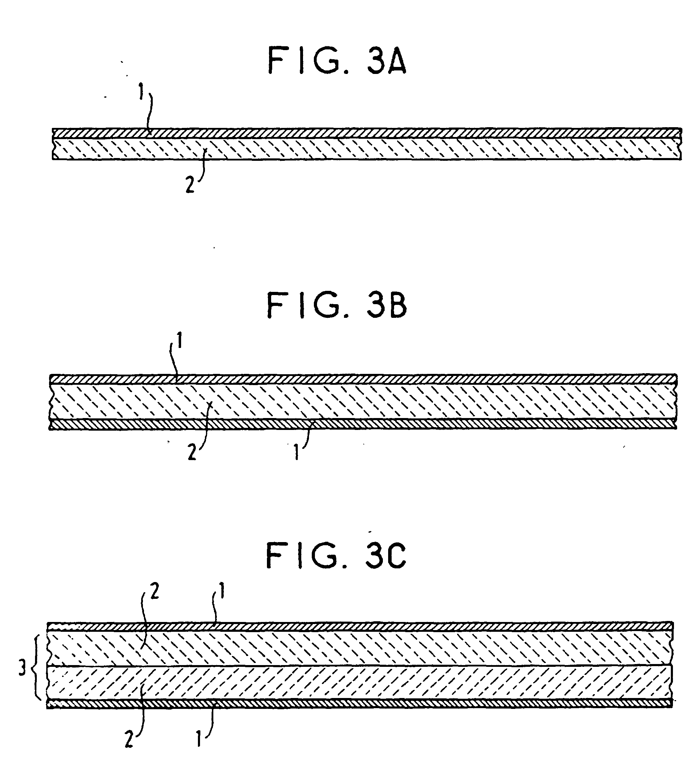

Les figures 3A à 3C sont des exemples de réalisation de matériau multicouche composite.

La figure 3A représente un matériau bi-couches ayant une feuille d'argent 1 et une couche de céramique non supraconductrice perméable à l'oxygène 2.

la figure 3B représente un matériau sandwich où la céramique non supraconductrice perméable à l'oxygène 2 est prise en sandwich entre deux feuilles d'argent 1. Cela s'obtient par compression à chaud du mélange homogène polymère/poudre entre deux feuilles à base d'argent. Cette variante de réalisation permet d'avoir une couche de céramique non supraconductrice perméable à l'oxygène 2 plus épaisses que dans le bi-couches.

La figure 3C représente deux bi-couches dont les couches de céramique non supraconductrice perméable à l'oxygène 2 sont au contact l'une de l'autre. Par cet artifice il est possible d'obtenir un matériau sandwich ayant une couche 3 (deux couches 2 superposées) de céramique non supraconductrice perméable à l'oxygène encore plus épaisse que dans le sandwich normal (fig 3B).

La mise en forme dû matériau bi-couches composite, en vue de son introduction entre la première et la deuxième épaisseur de matériau à base d'argent est avantageusement réalisée de telle manière que la couche de céramique non supraconductrice perméable à l'oxygène soit mise en compression.

Dans le cas du sandwich normal, les fissures pouvant apparaître du coté de la ligne neutre en traction, seront comblées par la céramique en compression de l'autre coté de la ligne neutre.

De même dans le cas du sandwich artificiel, les fissures pouvant apparaître du côté bi-couches en traction seront comblées par la céramique en compression de l'autre coté du plan de glissement.

Dans le cas des sandwichs, en cas de recouvrement l'une sur l'autre des extrémités du matériau multicouche composite, il faut prévoir un découplage des feuilles d'Ag venant en recouvrement.

L'épaisseur de la couche de mélange homogène polymère/poudre, et donc l'épaisseur de la couche de céramique non supraconductrice perméable à l'oxygène initiale est calculée en fonction de l'épaisseur de céramique non supraconductrice perméable à l'oxygène, voulue autour des filaments du nouveau brin multifilamentaire en fin du procédé. Par exemple, si l'on souhaite avoir une épaisseur de 1 à 2 µm de céramique non supraconductrice perméable à l'oxygène autour du filament en fin du procédé, et si l'on opte pour une réduction du filament de 400 entre le monofilament et le filament du nouveau brin multifilamentaire en fin du procédé, il faut prévoir une épaisseur initiale de céramique non supraconductrice perméable à l'oxygène dans le monofilament de l'ordre de 400 à 800 µm.

L'invention concerne aussi un brin multifilamentaire supraconducteur HTc comprenant une pluralité de filaments supraconducteurs 10, chaque filament supraconducteur 10 comprenant un coeur en céramique supraconductrice HTc 11, ledit coeur en céramique supraconductrice HTc 11 étant entouré par une première gaine en alliage à base d'Ag 12, elle même entourée par une couche de céramique non supraconductrice perméable à l'oxygène 13, elle même entourée d'une seconde gaine en alliage à base d'Ag 14.

La poudre ceramique est à base de Bi2212 pollué par de l'Al, ou du Mg, ou du Ti, ou à base de Bi2201.

Les filaments supraconducteurs HTc 10 constitutifs du brin sont contenus dans une gaine d'alliage résistif 15.

Bien entendu, l'invention n'est pas limitée aux modes de réalisation décrits et représentés, mais elle est susceptible de nombreuses variantes accessibles à l'homme du métier sans que l'on s'écarte de l'invention. En particulier, la coupe transversale des filaments peut être différente par exemple ronde ou hexagonale sans que l'on s'écarte de l'invention. La disposition des filaments dans le brin peut aussi être differente sans que l'on s'ecarte de l'invention. En particulier, les filaments peuvent être disposés par couches décalées.

## Revendications (Revendications pour l'(les) Etat(s) contractant(s) suivant(s): DE, GB, IT)

1. Brin multifilamentaire supraconducteur HTc comprenant une pluralité de filaments supraconducteurs (10), chaque filament supraconducteur (10) comprenant un coeur en céramique supraconductrice HTc (11), ledit coeur en céramique supraconductrice HTc (11) étant entouré par une première gaine en alliage à base d'Ag (12), elle même entourée par une couche de céramique non supraconducteur perméable à l'oxygène (13), elle même entourée d'une seconde gaine en alliage à base d'Ag (14) **caractérisé en ce que** ladite couche de céramique non supraconducteur perméable à l'oxygène (13) est à base de de Bi2212 pollué par de l'Al, ou du Mg, ou du Ti.

2. Brin multifilamentaire supraconducteur HTc comprenant une pluralité de filaments supraconducteurs (10), chaque filament supraconducteur (10) comprenant un coeur en céramique supraconductrice HTc (11), ledit coeur en céramique supraconductrice HTc (11) étant entouré par une première gaine en alliage à base d'Ag (12), elle même entourée par une couche de céramique non supraconducteur perméable à l'oxygène (13), elle même entourée d'une seconde gaine en alliage à base d'Ag (14) **caractérisé en ce que** ladite couche de céramique non supraconducteur perméable à l'oxygène (13) est à base de Bi2201.

3. Brin multifilamentaire supraconducteur HTc selon la revendication 1 ou 2 **caractérisé en ce que** les filaments supraconducteurs HTc (10) constitutifs du brin sont contenus dans une gaine d'alliage résistif (15).

4. Brin multifilamentaire supraconducteur HTc selon la revendication 3 **caractérisé en ce que** la section des billettes mono et multifilamentaires a une forme carrée ou rectangulaire.

5. Brin multifilamentaire supraconducteur HTc selon la revendication 3 **caractérisé en ce que** la section des billettes mono et multifilamentaires a une forme ronde ou hexagonale.

6. Procédé de fabrication du type poudre en tube d'un brin multifilamentaire supraconducteur HTc à matrice à base d'argent selon l'une quelconque des revendications 1 à 5, dans lequel:
dans une étape monofilamentaire, on remplit une première enveloppe à base d'argent, de réactifs poudreux susceptibles après traitement thermique de se transformer en matériau supraconducteur HTc;
on étire la billette résultante en un brin monofilamentaire;
dans une première étape multifilamentaire, on tronçonne ledit brin monofilamentaire et on remplit une enveloppe secondaire à base d'argent avec les tronçons résultants, réalisant ainsi une billette multifilamentaire, la billette multifilamentaire étant étirée à son tour en un brin multifilamentaire;
dans une étape multifilamentaire secondaire, réalisées au moins une fois,
on tronçonne ledit brin multifilamentaire et on remplit une nouvelle enveloppe à base d'argent avec les tronçons résultants, réalisant ainsi une nouvelle billette multifilamentaire, la nouvelle billette multifilamentaire étant étirée à son tour en un nouveau brin multifilamentaire;
on réalise une mise en forme du nouveau brin multifilamentaire;
on effectue un traitement thermique du brin mis en forme;
le procédé est **caractérisé en ce que** :
on prépare un matériau multicouche composite comprenant au moins une feuille à base d'argent et au moins une couche de matériau céramique perméable à l'oxygène non supraconductrice à base de de Bi2212 pollué par exemple par de l'Ag, ou du Mg, ou du Ti ou à base de Bi2201, et
durant l'étape monofilamentaire on intercale une épaisseur de matériau multicouche composite entre une première et une deuxième épaisseur de matériau à base d'argent, formant ainsi ladite une première enveloppe à base d' argent.

7. Procédé selon la revendication 6 **caractérisé en ce qu'**en coupe transversale, la première enveloppe à base d'argent, le brin monofilamentaire, l'enveloppe secondaire àbase d'argent, le brin multifilamentaire, la nouvelle enveloppe à base d'argent, le nouveau brin multifilamentaire, ont une forme générale carrée ou rectangulaire.

8. Procédé selon la revendication 6 ou 7 **caractérisé en ce que** pour préparer le matériau multicouche composite,
on mélange un polymère avec une poudre susceptible après traitement thermique de se transformer en matériau céramique non supraconductrice perméable à l'oxygène, à une température de l'ordre de la température de fusion du polymère utilisé, pour obtenir un mélange homogène polymère/poudre
on compresse à chaud, au moins une feuille d'argent 5 avec le mélange homogène polymère/poudre à une température de l'ordre de la température de fusion du polymère utilisé, pour obtenir un matériau intermédiaire multicouches composite alliage d'argent et mélange homogène polymère/poudre,
on cuit le matériau multicouches composite alliage d'argent/mélange homogène polymère/poudre à une température de l'ordre de la température de fusion de la poudre pour éliminer le polymère, assurer la synthèse de la poudre en céramique non supraconductrice perméable à l'oxygène et assurer l'adhérence de la céramique non supraconductrice perméable à l'oxygène à la feuille d'argent, réalisant ainsi le matériau multicouche composite.

9. Procédé selon la revendication 8 **caractérisé en ce qu'**on compresse à chaud le mélange homogène polymère/poudre entre deux feuilles à base d'argent.

10. Procédé selon la revendications 8 ou 9 **caractérisé en ce qu'**on choisit l'épaisseur de la couche de mélange homogène polymère/poudre en fonction de l'épaisseur de céramique non supraconductrice perméable à l'oxygène, voulue autour des monofilaments du nouveau brin multifilamentaire mis en forme.

## Revendications (Revendications pour l'(les) Etat(s) contractant(s) suivant(s): NL, SE)

1. Brin multifilamentaire supraconducteur HTc comprenant une pluralité de filaments supraconducteurs (10), chaque filament supraconducteur (10) comprenant un coeur en céramique supraconductrice HTc (11), ledit coeur en céramique supraconductrice HTc (11) étant entouré par une première gaine en alliage à base d'Ag (12), elle même entourée par une couche de céramique non supraconducteur perméable à l'oxygène (13), elle même entourée d'une seconde gaine en alliage à base d'Ag (14) **caractérisé en ce que** ladite couche de céramique non supraconducteur perméable à l'oxygène (13) est à base de de Bi2212 pollué par exemple par de l'Al, ou du Mg, ou du Ti.

2. Brin multifilamentaire supraconducteur HTc comprenant une pluralité de filaments supraconducteurs (10), chaque filament supraconducteur (10) comprenant un coeur en céramique supraconductrice HTc (11), ledit coeur en céramique supraconductrice HTc (11) étant entouré par une première gaine en alliage à base d'Ag (12), elle même entourée par une couche de céramique non supraconducteur perméable à l'oxygène (13), elle même entourée d'une seconde gaine en alliage à base d'Ag (14) **caractérisé en ce que** ladite couche de céramique non supraconducteur perméable à l'oxygène (13) est à base de Bi2201.

3. Brin multifilamentaire supraconducteur HTc selon la revendication 1 ou 2 **caractérisé en ce que** les filaments supraconducteurs HTc (10) constitutifs du brin sont contenus dans une gaine d'alliage résistif (15).

4. Brin multifilamentaire supraconducteur HTc selon la revendication 3 **caractérisé en ce que** la section des billettes mono et multifilamentaires a une forme carrée ou rectangulaire.

5. Brin multifilamentaire supraconducteur HTc selon la revendication 3 **caractérisé en ce que** la section des billettes mono et multifilamentaires a une forme ronde ou hexagonale.

6. Procédé de fabrication du type poudre en tube d'un brin multifilamentaire supraconducteur HTc à matrice à base d'argent selon l'une quelconque des revendications 1 à 5, dans lequel :
dans une étape monofilamentaire, on remplit une première enveloppe à base d'argent, de réactifs poudreux susceptibles après traitement thermique de se transformer en matériau supraconducteur HTc;
on étire la billette résultante en un brin monofilamentaire;
dans une première étape multifilamentaire, on tronçonne ledit brin monofilamentaire et on remplit une enveloppe secondaire à base d'argent avec les tronçons résultants, réalisant ainsi une billette multifilamentaire, la billette multifilamentaire étant étirée à son tour en un brin multifilamentaire;
dans une étape multifilamentaire secondaire, réalisées au moins une fois,
on tronçonne ledit brin multifilamentaire et on remplit une nouvelle enveloppe à base d'argent avec les tronçons résultants, réalisant ainsi une nouvelle billette multifilamentaire, la nouvelle billette multifilamentaire étant étirée à son tour en un nouveau brin multifilamentaire;
on réalise une mise en forme du nouveau brin multifilamentaire;
on effectue un traitement thermique du brin mis en forme;
le procédé est **caractérisé en ce que** :
on prépare un matériau multicouche composite comprenant au moins une feuille à base d'argent et au moins une couche de matériau céramique perméable a l'oxygène non supraconductrice à base de de Bi2212 pollué par exemple par de l'Ag, ou du Mg, ou du Ti ou à base de Bi2201, et
durant l'étape monofilamentaire on intercale une épaisseur de matériau multicouche composite entre une première et une deuxième épaisseur de matériau à base d'argent, formant ainsi ladite une première enveloppe à base d' argent.

7. Procédé selon la revendication 6 **caractérisé en ce qu'**en coupe transversale, la première enveloppe à base d'argent, le brin monofilamentaire, l'enveloppe secondaire àbase d'argent, le brin multifilamentaire, la nouvelle enveloppe à base d'argent, le nouveau brin multifilamentaire, ont une forme générale carrée ou rectangulaire.

8. Procédé selon la revendication 6 ou 7 **caractérisé en ce que** pour préparer le matériau multicouche composite,
on mélange un polymère avec une poudre susceptible après traitement thermique de se transformer en matériau céramique non supraconductrice perméable à l'oxygène, à une température de l'ordre de la température de fusion du polymère utilisé, pour obtenir un mélange homogène polymère/poudre
on compresse à chaud, au moins une feuille d'argent 5 avec le mélange homogène polymère/poudre à une température de l'ordre de la température de fusion du polymère utilisé, pour obtenir un matériau intermédiaire multicouches composite alliage d'argent et mélange homogène polymère/poudre,
on cuit le matériau multicouches composite alliage d'argent/mélange homogène polymère/poudre à une température de l'ordre de la température de fusion de la poudre pour éliminer le polymère, assurer la synthèse de la poudre en céramique non supraconductrice perméable à l'oxygène et assurer l'adhérence de la céramique non supraconductrice perméable à l'oxygène à la feuille d'argent, réalisant ainsi le matériau multicouche composite.

9. Procédé selon larevendication 8 **caractérisé en ce qu'**on compresse à chaud le mélange homogène polymère/poudre entre deux feuilles à base d'argent.

10. Procédé selon la revendications 8 ou 9 **caractérisé en ce qu'**on choisit l'épaisseur de la couche de mélange homogène polymère/poudre en fonction de 'l'épaisseur de céramique non supraconductrice perméable à l'oxygène, voulue autour des monofilaments du nouveau brin multifilamentaire mis en forme.

## Patentansprüche (Patentansprüche für folgende(n) Vertragsstaat(en): DE, GB, IT)

1. HTc supraleitender multifilamentärer Draht, welcher eine Mehrzahl von supraleitenden Filamenten (10) aufweist, wobei jedes supraleitende Filament (10) einen Kern aus HTc supraleitender Keramik (11) aufweist, wobei der Kern aus HTc supraleitender Keramik von einem ersten Mantel aus einer Legierung auf Silberbasis (12) umgeben ist, welcher wiederum von einer nicht supraleitenden sauerstoffdurchlässigen Keramikschicht (13) umgeben ist, die wiederum von einem zweiten Mantel aus einer Legierung auf Silberbasis (14) umgeben ist, **dadurch gekennzeichnet, dass** die nicht supraleitende sauerstoffdurchlässige Keramikschicht (13) auf einer Basis von Bi2212 ist, welches durch AL oder Mg oder Ti verunreinigt ist.

2. HTc supraleitender multifilamentärer Draht, welcher eine Mehrzahl von supraleitenden Filamenten (10) aufweist, wobei jedes supraleitende Filament (10) einen Kern aus HTc supraleitender Keramik (11) aufweist, wobei der Kern aus HTc supraleitender Keramik von einem ersten Mantel aus einer Legierung auf Silberbasis (12) umgeben ist, welcher wiederum von einer nicht supraleitenden sauerstoffdurchlässigen Keramikschicht (13) umgeben ist, die wiederum von einem zweiten Mantel aus einer Legierung auf Silberbasis (14) umgeben ist, **dadurch gekennzeichnet, dass** die nicht supraleitende sauerstoffdurchlässige Keramikschicht (13) auf einer Basis von Bi2201 ist.

3. HTc supraleitender multifilamentärer Draht gemäß Anspruch 1 oder 2, **dadurch gekennzeichnet, dass** die HTc supraleitenden Filamente (10), die den Draht bilden, in einem Mantel aus einer resistiven Legierung (15) enthalten sind.

4. HTc supraleitender multifilamentärer Draht gemäß Anspruch 3, **dadurch gekennzeichnet, dass** der Querschnitt der mono- und multifilamentären Blöcke eine viereckige oder rechteckige Form aufweist.

5. HTc supraleitender multifilamentärer Draht gemäß Anspruch 3, **dadurch gekennzeichnet, dass** der Querschnitt der mono- und multifilamentären Blöcke eine runde oder hexagonale Form aufweist.

6. Verfahren zur Herstellung der Art "Powder in Tube" eines HTc supraleitenden multifilamentäreren Drahts mit silberner Matrix gemäß irgend einem der Ansprüche 1 bis 5, in welchem:
in einem monofilamentären Schritt eine erste Umhüllung auf Silberbasis mit pulverförmigen Reagenzmitteln gefüllt wird, die nach Wärmebehandlung in der Lage sind, sich in ein HTc supraleitendes Material umzuwandeln;
der sich daraus ergebende Block zu einem monofilamentären Draht gezogen wird;
in einem ersten multifilamentären Schritt der monofilamentäre Draht in Stücke geteilt wird und eine zweite Umhüllung auf Silberbasis mit den sich ergebenden Stücken gefüllt wird, wodurch somit ein multifilamentärer Block hergestellt wird, wobei der multifilamentäre Block wiederum zu einem multifilamentären Draht gezogen wird;
in einem zweiten multifilamentären Schritt, welcher wenigstens ein Mal durchgerührt wird, der multifilamentäre Draht in Stücke geteilt wird und eine neue Umhüllung auf Silberbasis mit den sich ergebenden Stücken gefüllt wird, wodurch somit ein neuer multifilamentärer Block hergestellt wird, wobei der neue multifilamentäre Block wiederum zu einem neuen multifilamentären Draht gezogen wird;
eine Aufbereitung des neuen multifilamentären Drahtes durchgeführt wird;
eine Wärmebehandlung des aufbereiteten Drahtes durchgeführt wird;
das Verfahren **dadurch gekennzeichnet ist, dass**:
ein Mehrschicht-Verbundstoff hergestellt wird, welcher wenigstens eine Silberfolie und wenigstens eine Schicht aus nicht supraleitendem sauerstoffdurchlässigem keramischen Material auf Basis von Bi2212, welches zum Beispiel durch Ag oder Mg oder Ti verunreinigt ist, aufweist, und
während des monofilamentären Schritts eine Lage aus dem Mehrschicht-Verbundstoff zwischen eine erste und eine zweite Lage des Materials auf Silberbasis eingeschoben wird, welche so eine erste Umhüllung auf Silberbasis bilden.

7. Verfahren gemäß Anspruch 6, **dadurch gekennzeichnet, dass** die erste Umhüllung auf Silberbasis, der monofilamentäre Draht, die zweite Umhüllung auf Silberbasis, der multifilamentäre Draht, die neue Umhüllung auf Silberbasis, der neue multifilamentäre Draht im Querschnitt eine im wesentlichen viereckige oder rechteckige Form aufweisen.

8. Verfahren gemäß Anspruch 6 oder 7, **dadurch gekennzeichnet, dass** für das Herstellen des Mehrschicht-Verbundstoffs
ein Polymer mit einem Pulver gemischt wird, das nach Wärmebehandlung in der Lage ist, sich in nicht supraleitendes sauerstoffdurchlässiges keramisches Material umzuwandeln, bei einer Temperatur im Größenbereich der bei der Fusion des Polymers verwendeten Temperatur, um eine homogene Mischung Polymer/Pulver zu erhalten in warmem Zustand wenigstens eine Silberfolie 5 mit der homogenen Mischung Polymer/Pulver bei einer Temperatur im Größenbereich der bei der Fusion des Polymers verwendeten Temperatur zusammengedrückt wird, um ein mehrschichtiges Verbundlegierung- Zwischenmaterial aus Silber und der homogenen Mischung Polymer/Pulver zu erhalten,
das mehrschichtige Verbundlegierungs- Material aus Silber/homogene Mischung Polymer/Pulver bei einer Temperatur im Größenbereich der bei der Fusion des Pulvers verwendeten Temperatur erhitzt wird, um das Polymer abzuspalten, was die Synthese des Pulvers in nicht supraleitende sauerstoffdurchlässige Keramik sicherstellt und die Adhäsionskraft der nicht supraleitenden sauerstoffdurchlässigen Keramik an der Silberfolie sicherstellt, womit der Multischicht-Verbundstoff hergestellt ist.

9. Verfahren gemäß Anspruch 8, **dadurch gekennzeichnet, dass** in warmem Zustand die homogene Mischung Polymer/Pulver zwischen zwei Silberfolien zusammengedrückt wird.

10. Verfahren gemäß Anspruch 8 oder 9, **dadurch gekennzeichnet, dass** eine Lage der Schicht der homogenen Mischung Polymer/Pulver in Abhängigkeit von der Lage aus nicht supraleitender sauerstoffdurchlässiger Keramik gewählt wird, welche man um die Monofilamente des aufbereiteten neuen multifilamentären Drahtes haben will.

## Patentansprüche (Patentansprüche für folgende(n) Vertragsstaat(en): NL, SE)

1. HTc supraleitender multifilameritärer Draht, welcher eine Mehrzahl von supraleitenden Filamenten (10) aufweist, wobei jedes supraleitende Filament (10) einen Kern aus HTc supraleitender Keramik (11) aufweist, wobei der Kern aus HTc supraleitender Keramik von einem ersten Mantel aus einer Legierung auf Silberbasis (12) umgeben ist, welcher wiederum von einer nicht supraleitenden sauerstoffdurchlässigen Keramikschicht (13) umgeben ist, die wiederum von einem zweiten Mantel aus einer Legierung auf Silberbasis (14) umgeben ist, **dadurch gekennzeichnet, dass** die nicht supraleitende sauerstoffdurchlässige Keramikschicht (13) auf einer Basis von Bi2212 ist, welches zum Beispiel durch AL oder Mg oder Ti verunreinigt ist.

2. HTc supraleitender multifilamentärer Draht, welcher eine Mehrzahl von supraleitenden Filamenten (10) aufweist, wobei jedes supraleitende Filament (10) einen Kern aus HTc supraleitender Keramik (11) aufweist, wobei der Kern aus HTc supraleitender Keramik von einem ersten Mantel aus einer Legierung auf Silberbasis (12) umgeben ist, welcher wiederum von einer nicht supraleitenden sauerstoffdurchlässigen Keramikschicht (13) umgeben ist, die wiederum von einem zweiten Mantel aus einer Legierung auf Silberbasis (14) umgeben ist, **dadurch gekennzeichnet, dass** die nicht supraleitende sauerstoffdurchlässige Keramikschicht (13) auf einer Basis von Bi2201 ist.

3. HTc supraleitender multifilamentärer Draht gemäß Anspruch 1 oder 2, **dadurch gekennzeichnet, dass** die HTc supraleitenden Filamente (10), die den Draht bilden, in einem Mantel aus einer resistiven Legierung (15) enthalten sind.

4. HTc supraleitender multifilamentärer Draht gemäß Anspruch 3, **dadurch gekennzeichnet, dass** der Querschnitt der mono- und multifilamentären Blöcke eine viereckige oder rechteckige Form aufweist.

5. HTc supraleitender multifilamentärer Draht gemäß Anspruch 3, **dadurch gekennzeichnet, dass** der Querschnitt der mono- und multifilamentären Blöcke eine runde oder hexagonale Form aufweist.

6. Verfahren zur Herstellung der Art "Powder in Tube" eines HTc supraleitenden multifilamentäreren Drahts mit silberner Matrix gemäß irgend einem der Ansprüche i bis 5, in welchem:
in einem monofilamentären Schritt eine erste Umhüllung auf Silberbasis mit pulverförmigen Reagenzmitteln gefüllt wird, die nach Wärmebehandlung in der Lage sind, sich in ein HTc supraleitendes Material umzuwandeln;
der sich daraus ergebende Block zu einem monofilamentären Draht gezogen wird;
in einem ersten multifilamentären Schritt der monofilamentäre Draht in Stücke geteilt wird und eine zweite Umhüllung auf Silberbasis mit den sich ergebenden Stücken gefüllt wird, wodurch somit ein multifilamentärer Block hergestellt wird, wobei der multifilamentäre Block wiederum zu einem multifilamentären Draht gezogen wird;
in einem zweiten multifilamentären Schritt, welcher wenigstens ein Mal durchgeführt wird, der multifilamentäre Draht in Stücke geteilt wird und eine neue Umhüllung auf Silberbasis mit den sich ergebenden Stücken gefüllt wird, wodurch somit ein neuer multifilamentärer Block hergestellt wird, wobei der neue multifilamentäre Block wiederum zu einem neuen multifilamentären Draht gezogen wird;
eine Aufbereitung des neuen multifilamentären Drahtes durchgeführt wird;
eine Wärmebehandlung des aufbereiteten Drahtes durchgeführt wird;
das Verfahren **dadurch gekennzeichnet ist, dass**:
ein Mehrschicht-Verbundstoff hergestellt wird, welcher wenigstens eine Silberfolie und wenigstens eine Schicht aus nicht supraleitendem sauerstoffdurchlässigem keramischen Material auf Basis von Bi2212, welches zum Beispiel durch Ag oder Mg oder Ti verunreinigt ist, aufweist, und
während des monofilamentären Schritts eine Lage aus dem Mehrschicht-Verbundstoff zwischen eine erste und eine zweite Lage des Materials auf Silberbasis eingeschoben wird, welche so eine erste Umhüllung auf Silberbasis bilden.

7. Verfahren gemäß Anspruch 6, **dadurch gekennzeichnet, dass** die erste Umhüllung auf Silberbasis, der monofilamentäre Draht, die zweite Umhüllung auf Silberbasis, der multifilamentäre Draht, die neue Umhüllung auf Silberbasis, der neue multifilamentäre Draht im Querschnitt eine im wesentlichen viereckige oder rechteckige Form aufweisen.

8. Verfahren gemäß Anspruch 6 oder 7, **dadurch gekennzeichnet, dass** für das Herstellen des Mehrschicht-Verbundstoffs
ein Polymer mit einem Pulver gemischt wird, das nach Wärmebehandlung in der Lage ist, sich in nicht supraleitendes sauerstoffdurchlässiges keramisches Material umzuwandeln, bei einer Temperatur im Größenbereich der bei der Fusion des Polymers verwendeten Temperatur, um eine homogene Mischung Polymer/Pulver zu erhalten in warmem Zustand wenigstens eine Silberfolie 5 mit der homogenen Mischung Polymer/Pulver bei einer Temperatur im Größenbereich der bei der Fusion des Polymers verwendeten Temperatur zusammengedrückt wird, um ein mehrschichtiges Verbundlegierung- Zwischenmaterial aus Silber und der homogenen Mischung Polymer/Pulver zu erhalten,
das mehrschichtige Verbundlegierungs- Material aus Silber/homogene Mischung Polymer/Pulver bei einer Temperatur im Größenbereich der bei der Fusion des Pulvers verwendeten Temperatur erhitzt wird, um das Polymer abzuspalten, was die Synthese des Pulvers in nicht supraleitende sauerstoffdurchlässige Keramik sicherstellt und die Adhäsionskraft der nicht supraleitenden sauerstoffdurchlässigen Keramik an der Silberfolie sicherstellt, womit der Multischicht-Verbundstoff hergestellt ist.

9. Verfahren gemäß Anspruch 8, **dadurch gekennzeichnet, dass** in warmem Zustand die homogene Mischung Polymer/Pulver zwischen zwei Silberfolien zusammengedrückt wird.

10. Verfahren gemäß Anspruch 8 oder 9, **dadurch gekennzeichnet, dass** eine Lage der Schicht der homogenen Mischung Polymer/Pulver in Abhängigkeit von der Lage aus nicht supraleitender sauerstoffdurchlässiger Keramik gewählt wird, welche man um die Monofilamente des aufbereiteten neuen multifilamentären Drahtes haben will.

## Claims (Claims for the following Contracting State(s): DE, GB, IT)

1. A HTc supraconductor muitifilament strand comprising a plurality of supraconductor filaments (10), each supraconductor filament (10) comprising a core of HTc supraconductive ceramic (11), said core of HTc ceramic supraconductive being surrounded by a first sheath of Ag-based alloy (12), iyself surrounded by a layer of non-supraconductor ceramic permeable to oxygen (13), itself surrounded by a second sheath of Ag-based alloy (14), **characterised in that** said layer of non-supraconductor ceramic permeable to oxygen (13) is based on Bi2212 contaminated by Al, or Mg, or Ti.

2. The HTc supraconductor multifilament strand comprising a plurality of supraconductor filaments (10), each supraconductor filament (10) comprising a core of HTc supraconductive ceramic (11), said core of supraconductive ceramic (11) being surrounded by a first sheath of Ag-based alloy (12), itself surrounded by a layer of non-supraconductor ceramic permeable to oxygen (13); itself surrounded by a second sheath of Ag-based alloy (14), **characterised in that** said layer of non-supraconductor ceramic permeable to oxygen (13) is based on Bi2201.

3. The HTc supraconductor multifilament strand as claimed in Claim 1 or 2, **characterised in that** the HTc supraconductor filaments (10) constituting the strand are contained in a sheath of resistive alloy (15).

4. The HTc supraconductor multifilament strand as claimed in Claim 3, **characterised in that** the section of the mono- and multifilament slugs has a square or rectangular shape.

5. The HTc multifilament supraconductor as claimed in Claim 3, **characterised in that** the section of the mono- and multifilament slugs has a round or hexagonal shape.

6. A production process of powder in tube type of a HTc supraconductor multifilament strand with silver-based matrix as claimed in any one of Claims 1 to 5, in which:
in a monofilament step a primary silver-based envelope is filled with pulverulent reagents capable after thermal treatment of being transformed into HTc supraconductor material;
the resulting slug is drawn into a monofilament strand;
in a first multifilament step said monofilament strand is cut into sections and a secondary silver-based envelope is filled with the resulting sections, thus creating a multifilament slug, the multifilament slug being drawn in turn into a multifilament strand;
in a secondary multifilament step, realised at least once,
said multifilament strand is cut into sections and a new silver-based envelope is fileld with the resulting sections, thus creating a new multifilament slug, the new multifilament slug being drawn in turn into a new multifilament strand;
the new multifilament strand is formed;
thermal treatment of the formed strand is performed;
the process is **characterised in that**:
a composite multilayer material comprising at least a silver-based sheet and at least a layer of non-supraconductive ceramic material, permeable to oxygen is prepared, based on Bi2212 contaminated for example by Al, or Mg, or Ti or based on Bi2201, and
during the monofilament step a thickness of composite multilayer material is put in between a first and second thickness of silver-based material, thus forming said first silver-based envelope.

7. The process as claimed in Claim 6, **characterised in that** in transverse section the first silver-based envelope, the monofilament strand, the secondary silver-based envelope, the multifilament strand, the new silver-based envelope, the new multifilament strand, have a general square or rectangular shape.

8. The process as claimed in Claim 6 or 7, **characterised in that** to prepare the composite multilayer material, a polymer is mixed with a powder capable after thermal treatment of being transformed into non-supraconductor ceramic material permeable to oxygen, at a temperature of the order of the melting temperature of the polymer utilised, to obtain a homogeneous polymer/powder mixture
at least a sheet of silver with the homogeneous polymer/powder mixture is compressed hot at a temperature of the order of the melting temperature of the polymer utilised, to obtain a composite multilayer intermediary material of silver alloy, and a homogeneous polymer/powder mixture,
the composite multilayer material of silver alloy/homogeneous polymer/powder mixture is cooked at a temperature of the order of the melting temperature of the powder to eliminate the polymer, ensure synthesis of the powder of non-supraconductive ceramic permeable to oxygen and ensure adherence of the non-supraconductor ceramic permeable to oxygen to the sheet of silver, thus producing the composite multilayer material.

9. The process as claimed in Claim 8, **characterised in that** the homogeneous polymer/powder mixture is hot-compressed between two silver-based sheets.

10. The process as claimed in Claims 8 or 9, **characterised in that** the thickness of the layer of homogeneous polymer/powder mixture is selected as a function of the thickness of non-supraconductive ceramic permeable to oxygen, which is wanted around the monofilaments of the new formed multifilament strand.

## Claims (Claims for the following Contracting State(s): NL, SE)

1. A HTc supraconductor muitifilament strand comprising a plurality of supraconductor filaments (10), each supraconductor filament (10) comprising a core of HTc supraconductive ceramic (11), said core of HTc ceramic supraconductive being surrounded by a first sheath of Ag-based alloy (12), iyself surrounded by a layer of non-supraconductor ceramic permeable to oxygen (13), itself surrounded by a second sheath of Ag-based alloy (14), **characterised in that** said layer of non-supraconductor ceramic permeable to oxygen (13) is based on Bi2212 contaminated for example by Al, or Mg, or Ti.

2. The HTc supraconductor multifilament strand comprising a plurality of supraconductor filaments (10), each supraconductor filament (10) comprising a core of HTc supraconductive ceramic (11), said core of supraconductive ceramic (11) being surrounded by a first sheath of Ag-based alloy (12), itself surrounded by a layer of non-supraconductor ceramic permeable to oxygen (13), itself surrounded by a second sheath of Ag-based alloy (14), **characterised in that** said layer of non-supraconductor ceramic permeable to oxygen (13) is based on Bi2201.

3. The HTc supraconductor multifilament strand as claimed in Claim 1 or 2, **characterised in that** the HTc supraconductor filaments (10) constituting the strand are contained in a sheath of resistive alloy (15).

4. The HTc supraconductor multifilament strand as claimed in Claim 3, **characterised in that** the section of the mono- and multifilament slugs has a square or rectangular shape.

5. The HTc multifilament supraconductor as claimed in Claim 3, **characterised in that** the section of the mono- and multifilament slugs has a round or hexagonal shape.

6. A production process of powder in tube type of a HTc supraconductor multifilament strand with silver-based matrix as claimed in any one of Claims 1 to 5, in which:
in a monofilament step a primary silver-based envelope is filled with pulverulent reagents capable after thermal treatment of being transformed into HTc supraconductor material;
the resulting slug is drawn into a monofilament strand;
in a first multifilament step said monofilament strand is cut into sections and a secondary silver-based envelope is filled with the resulting sections, thus creating a multifilament slug, the multifilament slug being drawn in turn into a multifilament strand;
in a secondary multifilament step, realised at least once,
said multifilament strand is cut into sections and a new silver-based envelope is fileld with the resulting sections, thus creating a new multifilament slug, the new multifilament slug being drawn in turn into a new multifilament strand;
the new multifilament strand is formed;
thermal treatment of the formed strand is performed;
the process is **characterised in that**:
a composite multilayer material comprising at least a silver-based sheet and at least a layer of non-supraconductive ceramic material, permeable to oxygen is prepared, based on Bi2212 contaminated for example by Al, or Mg, or Ti or based on Bi2201, and
during the monofilament step a thickness of composite multilayer material is put in between a first and second thickness of silver-based material, thus forming said first silver-based envelope.

7. The process as claimed in Claim 6, **characterised in that** in transverse section the first silver-based envelope, the monofilament strand, the secondary silver-based envelope, the multifilament strand, the new silver-based envelope, the new multifilament strand, have a general square or rectangular shape.

8. The process as claimed in Claim 6 or 7, **characterised in that** to prepare the composite multilayer material,
a polymer is mixed with a powder capable after thermal treatment of being transformed into non-supraconductor ceramic material permeable to oxygen, at a temperature of the order of the melting temperature of the polymer utilised, to obtain a homogeneous polymer/powder mixture
at least a sheet of silver with the homogeneous polymer/powder mixture is compressed hot at a temperature of the order of the melting temperature of the polymer utilised, to obtain a composite multilayer intermediary material of silver alloy, and a homogeneous polymer/powder mixture,
the composite multilayer material of silver alloy/homogeneous polymer/powder mixture is cooked at a temperature of the order of the melting temperature of the powder to eliminate the polymer, ensure synthesis of the powder of non-supraconductive ceramic permeable to oxygen and ensure adherence of the non-supraconductor ceramic permeable to oxygen to the sheet of silver, thus producing the composite multilayer material.

9. The process as claimed in Claim 8, **characterised in that** the homogeneous polymer/powder mixture is hot-compressed between two silver-based sheets.

10. The process as claimed in Claims 8 or 9, **characterised in that** the thickness of the layer of homogeneous polymer/powder mixture is selected as a function of the thickness of non-supraconductive ceramic permeable to oxygen, which is wanted around the monofilaments of the new formed multifilament strand.
